# EUROPEAN PATENT APPLICATION

(11) **EP 0 529 330 A2**
(43) Date of publication of application: **03.03.1993**
(21) Application number: 92112859.1
(22) Date of filing: 28.07.1992
(51) Int. Cl.: G06F 11/20

(54) **System with laser link decoder for DRAM redundancy scheme**

(30) Priority: 31.07.1991 US 739047
(71) Applicant: TEXAS INSTRUMENTS INCORPORATED, Dallas Texas 75265 (US)
(72) Inventor: Tran, Hiep V., Carrollton, Texas 75009 (US)
(74) Representative: Schwepfinger, Karl-Heinz, Dipl.-Ing.

(57) **Abstract**

A decoder for a memory redundancy scheme is disclosed which allows replacement of a number of memory cell locations in connection with the state of a plurality of fuses.

## Description

### FIELD OF THE INVENTION

This invention is in the field of integrated circuits and is specifically directed to memories.

### BACKGROUND OF THE INVENTION

Electronic devices and systems such as printers, copiers, electronic storage devices (memories), high definition television, enhanced definition television telecommunication systems and computational devices (e.g. calculators and computers including personal computers, mini computers, workstations including scientific work stations, personal computers and micro computers) requiring electronic storage devices, often provide data storage on an integrated circuit chip. Because these devices often require large amounts of storage space for many applications, these storage devices are embodied in memory, for instance, a dynamic random access memory (DRAM). A decoder, particularly a laser link decoder, forms an integral part of the dynamic random access memory and it is also an integral part of the above described devices and systems, supplying substantial value to these and other devices and systems in which it is used.

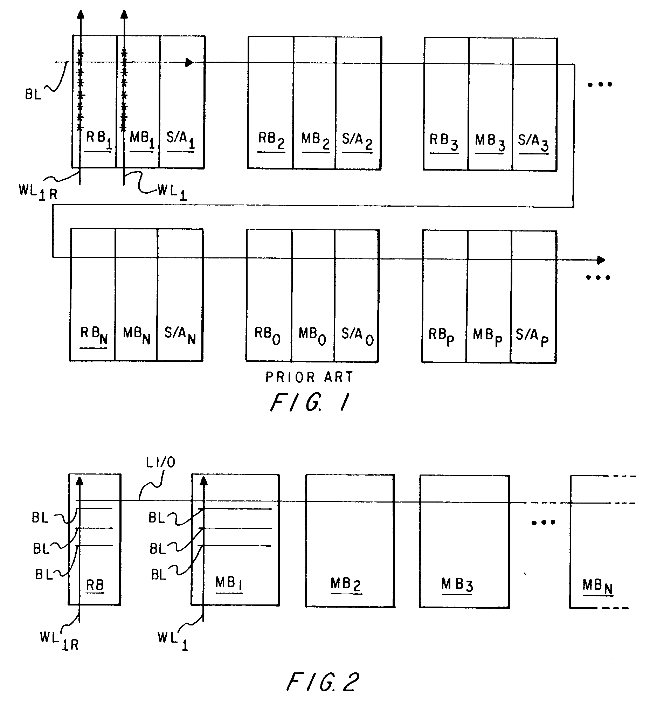

Figure 1 illustrates a schematic drawing of a prior art dynamic random access memory (DRAM) redundancy scheme which includes each memory block, labeled MB with an identifying subscript, and a plurality of redundant blocks of memory, RB, each associated with a memory block and carrying the same subscript. Each redundant block of memory RB and its associated memory block MB share bit lines (each bit line represented as BL). A plurality of sense amplifiers is also shown in figure 1 with each sense amplifier S/A (hereinafter referred to as sense amp) lying adjacent to and carrying the same subscript as its associated memory block. Redundant blocks of memory serve to provide alternate memory service. For instance, if word line WL₁ or memory cell along word line WL₁ in memory block MB₁ is defective, word line WL_{1R} in redundant memory block RB₁ is used along with its row (illustrated as verticle columns) of memory cells (each asterisk representing a memory cell).

### BRIEF DESCRIPTION OF THE DRAWINGS

Figure 1 illustrates a schematic drawing of a prior art dynamic random access memory (DRAM) redundancy scheme.

Figure 2 illustrates a schematic drawing of a first preferred embodiment of the invention's DRAM redundancy scheme.

Figure 3 illustrates diagram of a first preferred layout of the invention implementing a 64 megabit DRAM with exploded views of selected components.

Figure 4 illustrates a diagram of a second preferred layout alternative to that shown in figure 3 for the invention implementing a 64 megabit DRAM.

Figure 5 illustrates a diagram of one possible scheme showing the use of the signal bits in selecting word lines for refresh.

Figure 6 illustrates a block diagram of the row redundancy scheme.

Figure 7 illustrates a schematic drawing of a row redundancy laser link decoder.

### DETAILED DESCRIPTION OF THE INVENTION

Figure 2 illustrates a schematic drawing of a first preferred embodiment of the invention's DRAM redundancy scheme. As shown, only one redundant block of memory RB is required for a plurality of memory blocks. Redundant block of memory RB has its own independent bitlines (each labeled BL) unlike that of the prior art in which bitlines of the redundant block and its associated memory block are shared. Here, local input/output (L I/O) data line is shared by redundant block of memory RB and a plurality of memory blocks MB. If there is a defect associated with word line WL₁ in memory block MB₁, then word line WL_{1R} from the redundant block is used along with its associated memory cells in redundant block RB. Alternatively, any word line and memory cells from any of the other blocks can be replaced through the use redundant block RB. The number of word lines and associated circuitry (i.e. memory cells) which can be corrected depends on the number of word lines and associated circuity in the redundant block. Thus, if the redundant block has 5 rows of memory cells, 5 word lines and their associated cells can be corrected from any of the memory blocks.

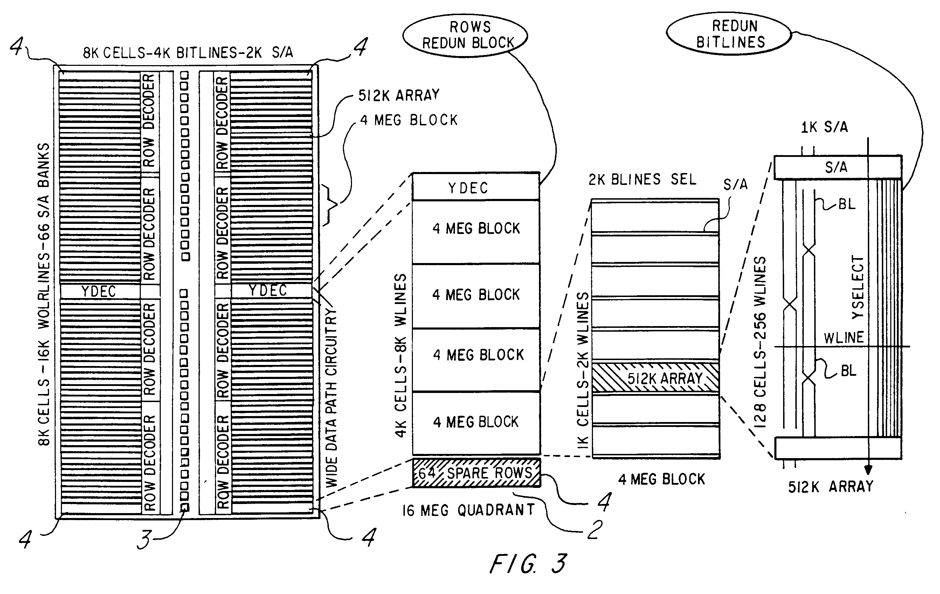

Figure 3 Illustrates a diagram of a first preferred layout of the invention implementing a 64 megabit DRAM with exploded views of selected components. There are 8000 (sk) memory cells, 16,000 (16k) word lines, and 2000 (2k) sense amps (S/A) in the 64 meg DRAM of figure 3. As illustrated, an exploded view of a section along the dashed line details one 16 megabit quadrant 2. There are 4000 (4k) memory cells and 8000 (8k) word lines in each 16 meg quadrant. Note that a block of redundant rows 4 exists for each 16 megabit quadrant of memory. In this example, there are 64 redundant rows of memory in each block of redundant rows 4. Each 16 megabit quadrant 2 is partitioned into four 4 megabit (4 meg) memory blocks with each block including four 512 kilobyte (512k) memory arrays. As shown, another exploded view of memory along dashed lines details a 4 meg block of memory. for ease of illustration, only one 512k array is labeled along with a section of sense amplifiers S/A. A section of sense amplifiers abuts each array. There are 1000 (1k) memory cells and 2000 (2k) word lines in each 4 meg block. The number of bitlines in a 4 meg block is on the order of 2000. The labeled 512k array and its associated sense amplifiers S/A are exploded into a more detailed view in which bit lines BLs are of the twisted variety. There are 128 memory cells and 256 word lines in each 512k array. Word line WLINE and bitline YSELECT indicate a word line and a bitline respectively, selected by a respective row decoder and column decoder YDEC. The intersection of a bitline with a word line as shown indicates the location of a chosen memory cell. The small section of closely spaced vertical lines labeled REDUN BITLINES indicates the bit lines for the redundant memory cells. Bond pads 3 for the address, control, and input/output (I/O) are represented by the small squares down the middle of chip 2. The location of wide data path circuitry is indicated as shown.

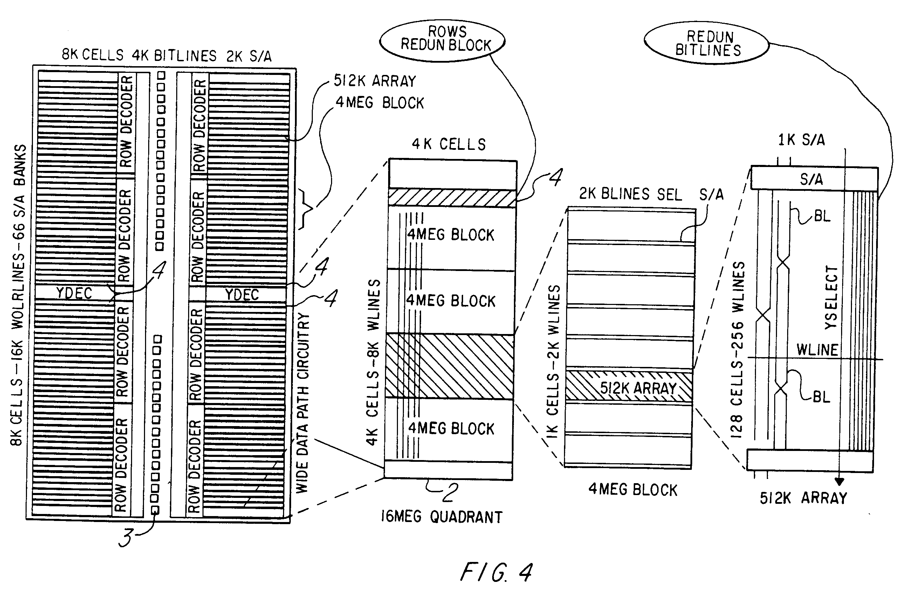

A second preferred layout alternative to that shown in figure 3 for the invention implementing a 64 megabit DRAM is illustrated in the diagram in figure 4. The position of the redundant blocks differs from that shown in figure 3. Note that the redundant blocks are near the column decoders (YDEC). This positioning of the redundant blocks near the column decoders can increase the operating speed of the memory.

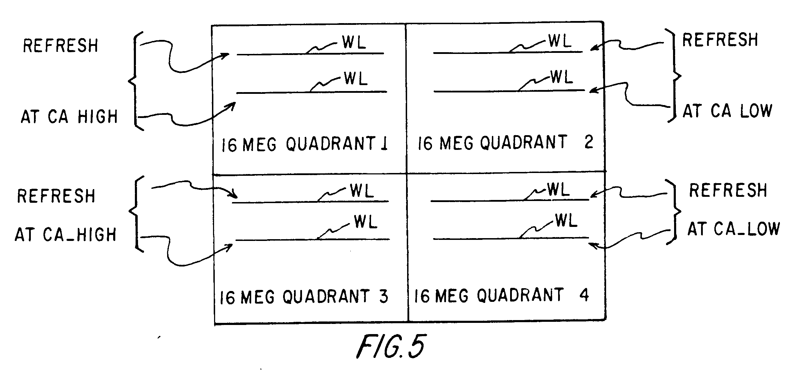

Memory cells of the DRAM must be refreshed to prevent loss of data. Generally, this is accomplished by the word line of a cell being energized so as to allow the cells's bitline to reinsert data to the cell via a sense amplifier. Refresh of a memory cell is required after reading data out of the cell. Refresh is also routinely required to prevent loss of memory storage through capacitor leakage. The refresh operation of the preferred embodiment of the 64 meg DRAM is such that 8k of memory cells are refreshed at a time. This translates into four word lines (2k memory cells on each word line) on the 64 meg chip being refreshed at the same time. Column address program (CA PROG) provides a signal bit either CA or CA_ which allows the selection of four word lines for refresh including any word lines from which the data of an associated cell is desired. Figure 5 illustrates a diagram of one possible scheme showing the use of the signal bits in selecting word lines for refresh. Memory cells of two word lines from a pair of diagonally positioned 16 meg quadrants are refreshed. For instance, when signal bit CA is logic high, signal bit CA_, its complement, is logic low. Consequently, in the scheme shown in figure 5, two word lines in 16 meg quadrant 1 are refreshed along with two word lines in 16 meg quadrant 4. Alternatively, when signal bit CA_ is logic high, its complement, signal bit CA is logic low, thereby resulting in two word lines in both 16 meg quadrants 2 and 3 being refreshed. In either of the cases given above concerning the logic states of signal bits CA and CA_, one of the word lines for a cell selected for refresh will be a word line for a cell selected for reading information therefrom. Refresh of the cells of the selected word line occurs after the selected cell information has been read, should the row address of a selected cell correspond to an address identified by circuitry (not shown) as having a defective word line, then replacement of the cell with a cell of a redundant word line takes place in accordance with the following description.

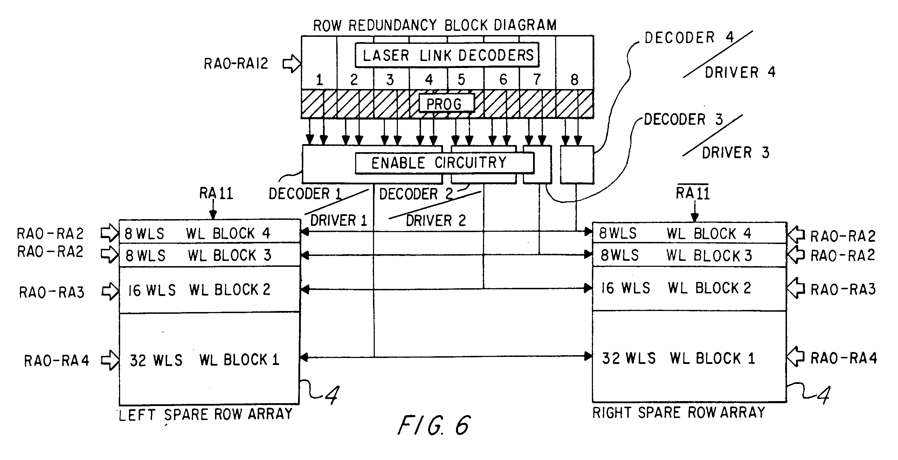

Figure 6 illustrates a block diagram of the row redundancy scheme. As shown, redundant rows 4, referenced respectively as left and right spare row arrays are each divided into 2 groups of 8 word lines (WLs), 1 group of the 16 WLs, and 1 group of 32 WLs. Enable circuitry comprising decoders labeled 1, 2, 3, and 4, enables redundant word line blocks labeled 1, 2, 3, and 4 to provide replacement for word line rows of memory within the 4 meg blocks based on signals received from a plurality of laser link decoders. Alternatively, instead of decoders, enable circuitry can comprise drivers, whereby redundant row selection in spare row arrays is determined by the plurality of laser link decoders. although only 8 laser link decoders are illustrated in figure 6, fewer or more may be used. The redundant memory along word lines are addressable by a portion of the address from the non redundant or rather main memory array. Thus, although the current address from main memory is for instance, 12 bits long, the redundant memory can for instance be addressed by 2 to 5 bits which can reflect the least significant 2 to 5 bits in the 12 bit long current address, as shown in figure 6. Word line block 1 comprises 32 word lines addressable by row addresses RAO to RA4, the five least significant bits of the current row address. Word line block 2 comprises 16 word lines addressable by row addresses RAO to RA3, the fourth least significant bits of the current row address. Word line block 3 comprises 8 word lines addressable by row addresses RA0 to RA2, the three least significant bits of the current row address. Word line block 4 comprises 8 word lines addressable by row addresses RA0 to RA2, the three least significant bits of the current row address. As a consequence of the above discussed addressability, should for instance, rows 3-10 of a first 4 meg block be defective, either of laser link decoders 1 to 4 could provide replacement of these defective rows with the available 32 word line rows of redundant memory in redundant block 1 addressed by RA0-RA4. If, for instance, in addition to the defective rows 3-10 of the first block, rows 3-10 of a second 4 meg block are defective, decoders 5 or 6 can provide replacement of the defective rows in the second block with redundant rows from the available 16 word line rows of redundant memory in redundant block 2 addressed by RA0-RA3. Further, if rows 3-10 of a third 4 meg block are additionally defective, decoder 7 can provide replacement of the defective rows in the third block with redundant rows from the available 8 word tine rows of redundant memory in redundant block 4 addressed by RA0-RA2. As shown, redundant word line blocks are in either a right or left spare row array. A right or left spare row selection is determined by row address RA11 and its complement RA11_ such that a high signal on an address bit indicates selection of a corresponding spare row array. An optimal replacement scheme for the memory can be determined by a computer program 9 (represented in figure 6 as PROG) using linear programming or other techniques. Alternatively, a computer program is not necessary to implement this aspect of the invention. Therefore, a human operator can determine the order of replacement.

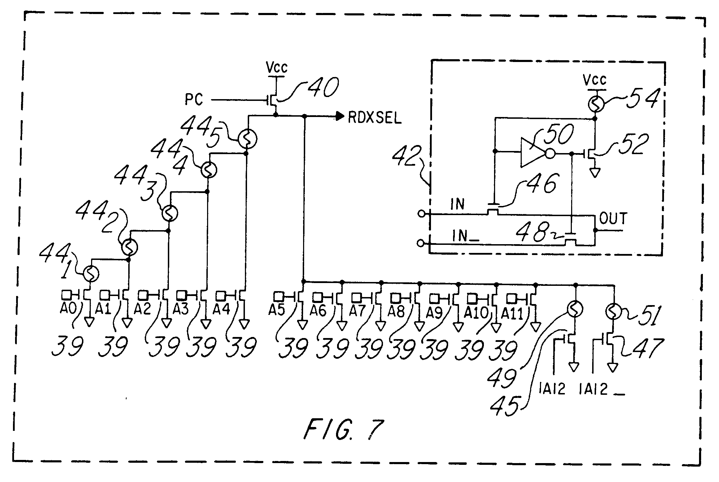

Figure 7 illustrates a schematic drawing of a row redundancy laser link decoder. A plurality of n-channel field effect transistors, each labeled 39, are coupled to and between redundancy select signal line RDXSEL and circuit ground. Alternatively, p-channel field effect transistors can be used in place of each transistor 39. Still alternatively, bipolar transistors can be used in place of transistor 39 with a base connection substituted for the gate connection together with collector emitter connections substituted for some combinations of drain and source connections. Decoder subcircuits, each labeled A followed by a number, are connected to the gate of an associated transistor 29. P-channel precharge transistor 40 is connected at its source to circuit supply voltage Vcc, while its drain is connected to line RDXSEL. Precharge signal PC is delivered to the gate of transistor 40. Precharge signal PC turns on transistor 40, resulting in precharging line RDXSEL to a logic high level. Fuse 44 is connected to and between the drains of adjacent transistors including transistors 29 and transistor 40. Transistors 45 and 47 are connected to ground and are each coupled to line RDXSEL through fuses 49 and 51 respectively. Note that transistors 45 and 47 along with their respective fuses 49 and 51, can be configured so as to deactivate a particular decoder by bringing its RDXSEL line low. Inputs to transistors 45 and 47 are labeled IA12 and IA12_. Square 42 in figure 7 illustrates a blown-up view of representative decoder subcircuit A. As shown in square 42, each subcircuit A has an output OUT and inputs, IN and IN_ which are connected to respective n-channel transistors 46 and 48. Each output OUT of subcircuit A is connected to an associated gate of one of the transistors labeled 39. The gate of transistor 46 is connected to the input of inverter 50 while the gate of transistor 48 is connected to the output of inverter 50. The gate of transistor 52 is connected to the output of inverter 50. The drain of pull-down n-channel transistor 52 is coupled to supply voltage Vcc through fuse 54 and it is connected to the input of inverter 50 and the gate of transistor 46. Fuses 54 of subcircuit A are blown corresponding to the binary ones of the address of the row of memory requiring replacement. A signal corresponding to a binary address bit along with a signal corresponding to the complement of the address bit is supplied to inputs IN and IN_, respectively, of an associated subcircuit A. A logic high signal corresponds to a logic 1 bit while a logic low signal corresponds to a logic 0 bit. 2¹² memory locations are indicated by figure 7, with a single corresponding to the least significant bit of an address being transmitted to subcircuit A0, and with each signal corresponding to a succeeding bit being transmitted to subcircuit A of a unit increment increase in the numerical portion of its label. For instance, a signal corresponding to the 12th bit of an address, along with a signal corresponding to the complement of the 12th bit of an address would be transmitted to inputs IN and IN_, respectively of subcircuit A11. Similarly, a signal corresponding to the 5th bit of an address, along with a signal corresponding to the complement of the 5th bit of an address would be transmitted to inputs IN and IN_ of subcircuit A4. Signals corresponding to all of the addresses of, for instance, a 16 megabit quadrant of memory are transmitted to the inputs of the A subcircuits in the manner set forth above.

If a high signal is sent to input IN and fuse 54 of the associated subcircuit A is not blown, inverter 50 keeps transistor 48 off, thus preventing the logic low signal at input IN_ from getting to output OUT. Additionally, transistor 52 is kept turned off. the logic high signal at input IN is transmitted to output OUT and transistor 39 connected to subcircuit A at its gate, pulls line RDXSEL down in voltage from its precharged level, thus indicating that the row of the current address (whose corresponding signals are now being input into subcircuits A) does not need replacement. A logic low signal at input IN of a subcircuit A whose fuse 54 is not blown results in transistors 48 and 52 being shut off. the logic low signal will be passed to output OUT, thus resulting in not pulling line RDXSEL down in voltage. This is a condition, as will be explained further below, which can lead to the replacement of a row by a redundant row. If however, fuse 54 of a subcircuit A is blown, a logic high signal at input IN of that subcircuit A, is not transmitted to output OUT since transistor 46 will be turned off due to the termination of the connection between voltage Vcc and its gate. Inverter 50 will turn on transistor 48 to allow transmission of the signal at input IN_ (in this case a logic low) to reach output OUT, resulting in not pulling line RDXSEL down. Furthermore, should a fuse 54 be blown, if any of the signals at IN_ is logic high (or rather a signal at input IN is logic low), a transistor 39 connected by its gate to the output of the subcircuit A with the logic high input IN_ signal will pull line RDXSEL low, thus indicating no need for replacement of a row corresponding to the current row address.

If line RDXSEL remains high after input of signals, corresponding to a row address, to the A subcircuits, this is sufficient to indicate that the row of the current row address needs replacement by the redundant row associated with the present row redundancy laser link decoder. should two or more rows in a block need replacement, a fuse 44 can be blown so as to allow the decoder to select redundant rows of memory for the defective rows, all preceding rows thereof, all subsequent rows up to an additional most significant bit address, and all intervening rows therebetween. Thus, if the third and the tenth row of a block needed replacement with a redundant row, fuse 44₄ is blown and redundant rows are selected to replace rows 1 through 16. Additionally, the redundant replacement scheme discussed with regard to figure 6 can be implemented for use in replacement of memory anywhere within a main memory array. For instance, although it is possible to replace the first 32 rows in a main memory block by blowing fuse 44₅, it is possible to replace other groups of 32 rows of memory depending upon the address identified as defective in the laser link decoder. For example, laser link decoder 3 may identify the 1035th address as defective. If in addition to this defective address, there exist other addresses in close proximity which are defective, fuse 44₅ can be blown so as to allow replacement of the 1024th to 1056th rows of memory, the 32nd group of 32 addresses in which the 1035 address falls.

Although the invention has been described in detail herein with reference to its preferred embodiment, it is to be understood that this description is by way of example only and is not to be construed in a limiting sense. It is to be further understood that numerous changes in the details of the embodiments of the invention, and additional embodiments of the invention, will be apparent to, and may be made by persons of ordinary skill in the art having reference to this description. For instance, although the foregoing invention has been described with regard to a DRAM, it may be used as a redundancy scheme for any memory including read only memories and static random access memories. Further, p-channel transistors, n-channel transistors, and bipolar transistors (n-type or p-type) can be substituted for each other throughout. Additionally, although fuses which are capable of being blown by lasers are discussed, other types of fuses are contemplated, such as electrically blown fuses. It is contemplated that all such changes and additional embodiments are within the true scope and spirit of the invention as claimed below.

Arrangements including a decoder as herein described may be made that a suitable for use in eletronic systems including printers, copiers, electronic storage devices (memories), high definition television, enhanced definition television, telecommunications and computational devices.

## Claims

1. A decoder comprising:
a plurality of transistors;
a signal line common to and connected to each of said plurality of transistors;
a plurality of input circuits, each input circuit being connected to an associated one of said plurality of transistors and including a fuse;
a plurality of fuses, being serially connected together, each fuse from said plurality being further connected to an associated one of said plurality of transistors.

2. A decoder as recited in claim 1 wherein each of said fuses are laser blowable.

3. A decoder as recited in claim 1 which further comprises precharge circuitry for connection to said signal line.

4. A decoder as recited in claim 1 wherein each said input circuit has first, second and third transistors, said first transistor being connected to the output of said inverter and said input circuit fuse, said second transistor being connected to the input of said inverter and said input circuit fuse, said third transistor being connected to said first and second transistors.

5. A decoder as recited in claim 1 which further includes: circuitry for disabling said decoder, said circuitry comprising a pair of transistors, each being operative to receive the complement of an input signal to the other from the pair; and a pair of fuses connected to said signal line, each said fuse from said pair being connected to an associated transistor from said pair.

6. A decoder as recited in claim 1, wherein each transistor is an n-channel transistor.

7. A decoder as recited in claim 1, wherein each transistor is a p-channel transistor.

8. A decoder as recited in claim 1, wherein each transistor is a bipolar transistor.

9. A decoder as recited in claim 4, wherein said first transistor is connected at its base to the output of said inverter and said third transistor and wherein said first transistor is connected at its drain to said input circuit fuse, the gate of said second transistor and the input of said inverter.

10. A dynamic random access memory including a decoder as claimed in any preceding claim.

11. An electronic system including a decoder as claimed in any of claims 1 to 9.

12. An electronic system including a dynamic random access memory as claimed in claim 10.

13. An electronic system as claimed in claim 11 or claim 12 wherein said system is selected from the group consisting of printers, copiers, electronic storage devices (memories), high definition television, enhanced definition television, telecommunications and computational devices.
